Europäisches Patentamt

European Patent Office

Office européen des brevets

(19)

(11) EP 0 694 630 A1

(12) EUROPEAN PATENT APPLICATION

(43) Date of publication:
31.01.1996 Bulletin 1996/05

(51) Int Cl.6: C23C 14/16, C23C 14/58,
C23C 8/36

(21) Application number: 95305103.4

(22) Date of filing: 21.07.1995

(84) Designated Contracting States:
AT BE DE FR GB IT NL SE

(30) Priority: 26.07.1994 US 280281

(71) Applicant: THE BOC GROUP, INC.
Murray Hill, New Jersey 07974 (US)

(72) Inventors:
• Chang, Ping
Danville, California 94506 (US)
• Jansen, Frank
Walnut Creek, California (US)

(74) Representative: Bousfield, Roger James et al
Windlesham, Surrey GU20 6HJ (GB)

(54) Protective treatment of metal substrates

(57) A method for improving corrosion resistance of a metallic substrate comprising:

providing a metallic substrate having a coating thereon, the coating defining an exposed initial surface based upon elemental aluminium or an aluminium alloy;

establishing a plasma in an evacuated chamber, the plasma derived from a gas stream, the plasma including a reactant which, when reacted with aluminium, forms an oxide or a halide; and

contacting the exposed initial surface to the plasma within the chamber to cause a plasma reaction in which the initial surface is reacted with the plasma to form a reacted surface with a corrosion resistant oxide or halide film for the substrate thereon.

## FIG. 1B  Inventive Embodiment

Distance to the Original Surface (angstroms)

## Description

This invention generally relates to improving corrosion resistance of metal substrates such as steel, and more particularly to a vacuum or plasma treatment that provides greatly improved corrosion resistance for metal substrates having an aluminium based protective layer.

The use of zinc and/or aluminium to protect ferrous materials has long been known. Thus, galvanizing is a coating of zinc typically performed by introducing the substrate into molten zinc through a layer of activating flux. The corrosion-resistant properties of galvanized products are satisfactory in many outdoor environments for various applications, and the duration of protection is typically directly proportional to the weight of zinc per unit area. Anodizing is a treatment of aluminium (and a few other metals) resulting in an oxide film formed on the metal surface. A thin oxide film will form on an aluminium surface without special treatment on exposure of the metal to air, and this provides good resistance to corrosion. In order to produce thicker and faster oxide films, electrochemical processes using sulphuric, oxalic, and chromic acids as electrolytes were developed.

However, the need exists for increased corrosion resistance than is obtained through zinc galvanized. For example, among the many applications for aluminium coated steel are architectural claddings and as automobile chassis, particularly where winter-salted roads or salty coastal fog subject the underlying steel substrates to extremely corrosive environments. And, of course, the corrosive acids used in electrochemical processes for rapid anodizing can pose environmental hazards during use and ultimately for disposal.

Corrosion-resistant metals such as aluminium are difficult to use in electroplating, but a technology developed in Russia has been introduced to coat a metal substrate under vacuum with aluminium by evaporation, as is described by Budyuk et al, "Protective-Aluminium Vacuum Deposition on Steel," *Technology of Applying Coatings* (1970).

Plasma or thermal spraying of aluminium is also done for protecting steel, steel alloys, and composites, and is described by the American Welding Society publication ANSI/AWS C 2.18-93, "Guide For The Protection of Thermal Sprayed Coatings of Aluminium and Zinc and Their Alloys and Composites" (1993). Another description of applying aluminium as a protective coating by plasma-spraying is disclosed in US Patent Specification No. 3,837,894. In such plasma sprayed aluminium protective coatings, air is present, and the molten aluminium forms an aluminium oxide layer; however, such coatings tend to be of relatively poor structural quality and have a porous surface morphology. For example, the above-noted American Welding Society publication states that "porosity is an inherent feature of thermal sprayed coatings," although the degree of porosity is a function of the feed stock material, the application method, and the spraying parameters. The most dense (lower porosity) thermal sprayed coatings are those with oxy-fuel flame spraying, small diameter wire (1.6 and 2.4 mm), low-current (100-200 amps) arc spraying. Because of their porosity, these coatings should normally be sealed or should be very thick (50 μm or more).

The present invention is concerned with the provision of a method for improving the corrosion resistance of a metallic substrate, such as steel, for a variety of applications where an increase in corrosion resistance is desired.

In accordance with the invention, a method is provided for improving corrosion resistance of a metallic substrate comprising:

providing a metallic substrate having a coating thereon, the coating defining an exposed initial surface based upon elemental aluminum or an aluminum alloy;

establishing a plasma in an evacuated chamber, the plasma derived from a gas stream, the plasma including a reactant which, when reacted with aluminum, forms an oxide or a halide; and

contacting the exposed initial surface to the plasma within the chamber to cause a plasma reaction in which the initial surface is reacted with the plasma to form a reacted surface with a corrosion resistant oxide or halide film for the substrate thereon.

The exposed initial surface preferably is obtained by evaporatively depositing aluminium or an aluminium alloy in an evacuated chamber as a very dense layer on to the substrate (or on to an intermediate coating interposed between the substrate and the deposited aluminium).

The initial aluminium or aluminium alloy surface is usually maintained under evacuated conditions until contacted with a plasma in an evacuated chamber. The plasma includes a reactant which, when reacted with the aluminium of the initial surface, forms an oxide or a halide. This reacted surface is a corrosion resistant oxide or halide film for the substrate, which provides greatly improved corrosion resistance, such as when compared with an aluminium oxide layer formed in air.

For example, coatings of the invention have been tested by salt fog tests (ASTM B117-87) representing accelerated exposures to corrosive environments. The steel substrates tested were coated and treated in accordance with the invention and have shown an improved corrosion resistance in the extremely corrosive 20 wt% salt mists of the salt fog tests up to twice that of analogously coated, but not plasma treated, substrates.

The inventive method is used with metallic substrates. Among the suitable substrates for practising the inventive method are aluminium and aluminium alloys, mild steel, wrought iron, low-alloy steel, cast iron, low-alloy cast iron, chromium steel, nickel cast iron, chromium-nickel stainless steel, chromium-nickel-molybdenum, manganese bronze, nickel-chromium alloys (such Inconel alloys) glass, bronze, copper, nickel-silver and copper nickel, among others. Substrates will typically be coiled rolls having from about 0.2 mm to about 1.5 mm thickness and widths between about 25 cm to about 185 cm.

The substrates, such as illustrated above, have an exposed initial surface based on elemental aluminium or an aluminium alloy. By the phrase the "exposed initial surface is based upon elemental aluminium or an aluminium alloy" is meant, for example, that zinc could be a component with aluminium in amounts from a trace up to about 90% with the remainder being aluminium or is meant that the surface has a density at least about 2.50 gm/cc (with respect to a bulk density of aluminium of 2.70 gm/cc), preferably where the initial surface is derived from a vacuum deposited aluminium or an aluminium alloy, such as having up to about 90% zinc.

Thus, a preferred first step in practising the inventive process is to evaporatively deposit aluminium or an aluminium alloy in an evacuated chamber and thus to form the initial surface for the substrate. The initial layer will have a thickness of more than about 100 Å and typically will be in a range up to a thickness of about 60 $\mu$m, and preferably is about 2 $\mu$m.

One or more layers or coatings may be interposed between the substrate and the initial aluminium or aluminium alloy layer. For example, a particularly preferred embodiment of practising the invention is wherein a zinc based layer is interposed between the substrate and the vacuum evaporated aluminium layer.

Where one or more layers is interposed between the initial aluminium-based or aluminium alloy-based surface and the substrate, such interposed layer or layers can be put on by known coating methods. An interposed zinc layer is preferred, although not necessary, and its presence provides protection from corrosion occurring after accidental scratching and the like.

The initial surface will be exposed to a plasma in an evacuated chamber. The chamber will be evacuated prior to plasma treating to a pressure on the order of about 1 millitorr or less. During the plasma reaction the pressure will typically be on the order of from about 1 millitorr to about 1 torr, more preferably from about 1 millitorr to about 50 millitorr. Relatively low pressure is preferred during the plasma reaction in order to provide high particle bombardments.

The plasma can be produced by a wide variety of electrical systems, either DC or AC or from a high density source. A plasma is defined to be a partially ionised gas composed of ions, electrons, and a variety of neutral species. A glow discharge is a plasma that exists in the pressure range of about 1 millitorr to about 1 torr, and contains approximately equal concentrations of positive particles (positive ions) and negative particles (electrons and negative ions). The density of these charged particles in glow discharges ranges from about $10^9$-$10^{11}$/cm$^3$, and the average energies of the electrons in glow discharges are between about 1-10eV.

The reactions that occur in the gas phase (plasma) are called homogeneous reactions, while those that occur at the surface are termed heterogeneous reactions. In practising the invention with a halogen containing species such as $CF_4$, the most abundant ionic specie found will be $CF_3^+$, along with $CF_3$ and F as abundant radicals. Practice of the invention is particularly focused on heterogeneous reactions of the exposed surface.

The parameters affecting the reaction include the surface temperature, the nature of the surface, the surface electrical potential and the geometrical aspects of the surface (such as surface roughness). It is preferred that the substrate is grounded during practice of the invention, with an electrically biased-electrode present in the grounded system.

Use of a DC discharge for generating the plasma in practising the invention typically involves a combination of a cathode surface, a cathode dark space region with associated large electric field, and negative glow regions. Ions, formed in the dark space, and negative glow regions are accelerated by the cathode electric field into the cathode surface, where they cause secondary electrode emission and sputtering. The secondary electrons are accelerated back across the dark space and cause ionization, either directly or by transferring their energy to electrons in the plasma. Either types of discharges (e.g. a hollow cathode discharge) rely on the formation of secondary electrons, which are the primary source of ionization which sustains the discharge.

There are some shortcomings of a DC glow discharge, which the use of an AC power source can alleviate. An RF discharge apparatus is similar to that for the DC discharge in that typically there is a cathode sheath and a quasi-negative glow. However, the electrons will generally cross the sheath region in a fraction of the RF period and the edge of the sheath will generally oscillate. The RF discharge is distinguished from the DC discharge because the RF field is changing direction in time and thus the RF discharge is more efficient. It is also possible to use microwave power to operate a discharge.

Suitable apparatus and aspects of plasma processing for practising the invention are known and are discussed in the art, for example in the *Handbook of Plasma Processing Technology* (edited by Rossnagel, Cuomo and Westwood, 1990, Noyes Publications).

The plasma chemically activates the gaseous reactants and is derived from a gas stream including the reactant, which, when reacted with aluminium, forms an oxide or a halide. The gas stream will typically include a carrier such as argon, helium, neon, or combinations thereof. Suitable gas streams for forming an oxide will include oxygen, ozone, hydrogen peroxide, and nitrous oxide. A suitable gas stream for forming a halide is carbon tetrafluoride, ammonia fluoride, and the like.

The substrate will preferably be heated during the plasma reaction, such as to an elevated temperature of at least about 100°C, and the plasma reaction will take place over a residence time of at least about 0.1 seconds more preferably of between about 1 to about 60 seconds.

In the drawings, provided by way of exemplifying the invention only:

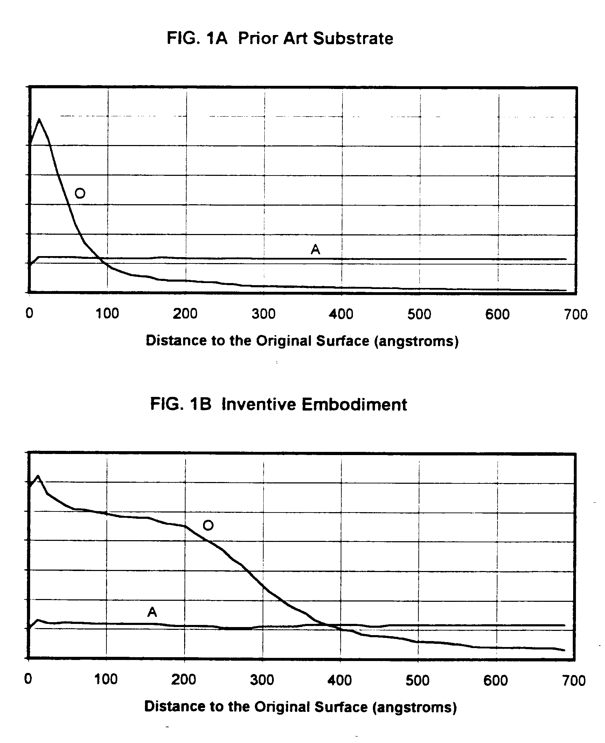

Figures 1A and 1B show the counting rate of photoelectrons which represent the concentrations of oxygen(O) and aluminium(A), resulting from an X-Ray Photoelectron Spectroscopy (XPS) depth profile characterization of the sample, as a function of distance to the original surface. Figure 1A pertains to the oxidation state of a prior art sample, in this case an aluminium film of 3 micron thickness, stored at ambient conditions after vacuum deposition for two weeks. Figure 1B pertains to the oxidation state of the inventive sample, in this case an aluminium film of 3 micron thickness, vacuum deposited under the identical conditions of the prior art sample but plasma oxidised in accordance with the invention for 15 seconds immediately after deposition.

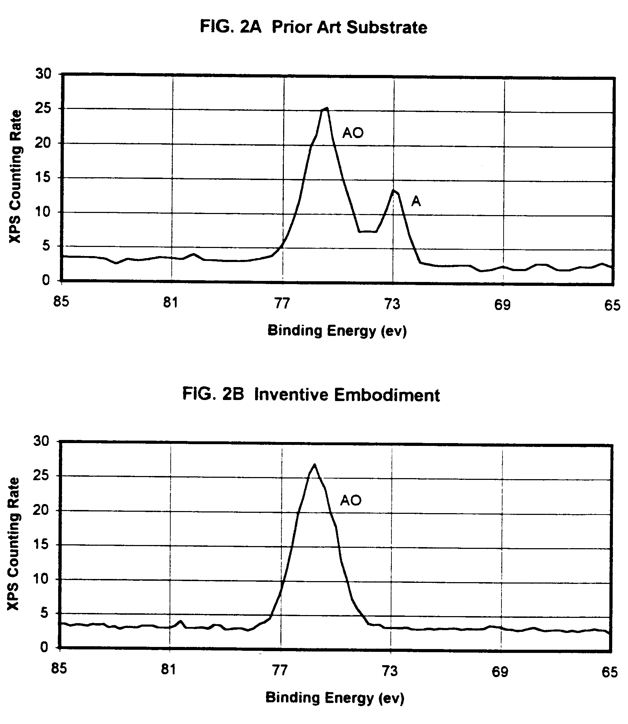

Figures 2A and 2B show data taken by use of the same method as in Figure 1, i.e. XPS. The vertical axis is the counting rate of photoelectrons as before, while the horizontal axis is the binding energy, which represents a type of chemical bond. In Figure 2A, which was a prior art substrate, the peak between about 75-77 was of aluminium oxide (AO)and the peak at about 73 was unoxidised aluminium (A), whereas the inventive embodiment data of Figure 2B shows a peak of aluminium oxide and no unreacted aluminium.

We had embodiments of the invention and prior art coated substrates tested. The inventive embodiments were compared to analogous aluminium coated substrates which were simply air-exposed rather than having been oxygen plasma treated. The data from these experiments are illustrated by Figures 1 and 2. The procedure utilized for generating this data was "XPS," which is X-Ray Photoelectron Spectroscopy.

Thus, turning to Figure 1, Figure 1A shows a "depth profile" of a prior art, air exposed substrate having an aluminium-zinc-titanium coating on steel while Figure 1B is the depth profile of an inventive embodiment, again with an aluminium-zinc-titanium coating on steel, but where the aluminium surface was oxygen plasma treated. The horizontal axes of both Figures 1A and 1B are distance to the original surface, in angstroms. Comparison of the data between Figures 1A and 1B indicate that the inventive oxygen plasma treatment increased surface oxide thickness significantly. Thus, the oxide layer thickness for the two week air exposed sample was 90 Å thick while the oxygen plasm treated substrate had an oxide layer thickness of 390 Å.

Turning to Figure 2, Figure 2A again represents data taken from the prior art substrate that had been air exposed for two weeks whereas Figure 2B represents data taken from an inventively treated substrate. In the prior art, Figure 2A data, a substantial amount of unoxidised aluminium metal was found upon an analysis of the surface (even after two weeks air exposure). By contrast and with reference to Figure 2B, the entire surface of the inventive embodiment was oxidised and there was no unoxidised aluminium present.

We believe that this fully oxidised surface, obtained from practice of the invention with some seconds of oxygen plasma treatment (embodiments tested for Figures 1B and 2B were obtained after 25 seconds of oxygen plasma treatment) is likely a significant factor in providing maximal corrosion resistance immediately after the inventive treatment. That is, we hypothesise (without being bound by theory) that it is the unreacted, or unoxidised, aluminium in aluminium surfaces that may cause the pitting occurring during corrosion. Thus, practice of the invention is believed very quickly to convert all surface aluminium into reacted or oxidised forms. Similarly, when an aluminium alloy is used as the initial surface, then it is believed that the alloy is reacted or oxidised so that no unreacted metal species remain.

We further compared inventively treated embodiments to prior art, air-exposed aluminium coated substrates by placing both the inventive embodiments and the comparative materials in a highly corrosive environment, the results of which are summarized in Table 1.

TABLE 1

| Experiment No. | Inventive Treated Embodiments (hrs in salt fog w/out red rust) | Comparative (hrs in salt fog w/out red rust) |
|---|---|---|
| 1 | 1288 | 832 |
| 2 | 1024 | 736 |
| 3 | 1120 | 688 |
| 4 | 1376 | 664 |
| 5 | 960 | 712 |
| 6 | 1490 | 712 |
| | average $\overline{1183}$ | average $\overline{717}$ |

As seen by the data summarized in Table 1, inventively treated embodiments survived an average of 1183 hours in the accelerated corrosive environment (20% salt fog) before developing red rust. By contrast, an analogous substrate, except without having been treated with the oxygen plasma treatment of the invention, survived an average of 717 hours before developing red rust.

The experiments were performed with cold rolled steel having a size of 4" x 6". Titanium layers were sputtering deposited at a thickness of 200 Å; after that zinc layers were evaporatively deposited at a thickness of 3 μm followed by vacuum evaporative coating of aluminium at a thickness of 3 μm. The substrates were at a temperature of 100°C and exposed to salt fog (20 wt%) up to the point when the articles began to develop visible, red rust, then removed. We conclude that the salt fog lifetime is significantly increased by the oxygen plasma treatment time, and that an increased residence time in the oxygen plasma (such as increased from 5 to 15 or 25 seconds) is preferable.

**Claims**

1. A method for improving corrosion resistance of a metallic substrate comprising:
   providing a metallic substrate having a coating thereon, the coating defining an exposed initial surface based upon elemental aluminium or an aluminium alloy;
   establishing a plasma in an evacuated chamber, the plasma derived from a gas stream, the plasma including a reactant which, when reacted with aluminium, forms an oxide or a halide; and
   contacting the exposed initial surface to the plasma within the chamber to cause a plasma reaction in which the initial surface is reacted with the plasma to form a reacted surface with a corrosion resistant oxide or halide film for the substrate thereon.

2. A method according to Claim 1 in which the exposed initial surface has a density of at least about 2.50 gm/cc.

3. A method according to Claim 1 or Claim 2 in which the exposed initial surface is derived from a vacuum deposited aluminium or a vacuum deposited aluminium-zinc alloy.

4. A method according to any preceding claim in which the gas stream includes a source of oxygen or a source of fluorine.

5. A method according to any preceding claim in which the chamber is maintained at a pressure between about 1 millitorr to about 1 torr during the plasma reaction.

6. A method according to any preceding claim in which the exposed initial surface is at an elevated temperature during the plasma reaction.

7. A method according to Claim 6 in which the contacting is for a residence time of between about 1 to about 60 seconds with an elevated temperature of at least about 100°C and a gas pressure of from about 1 millitorr to about 1 torr.

8. A method according to any preceding claim in which the elemental aluminium or aluminium alloy is a layer with a thickness of more than about 100 Å.

9. A method according to any preceding claim in which a zinc based layer is interposed between the substrate and the aluminium or aluminium alloy layer.

10. A method according to any preceding claim in which the metallic substrate is a steel and the coating is a zinc-aluminium alloy.

## FIG. 1A  Prior Art Substrate

Distance to the Original Surface (angstroms)

## FIG. 1B  Inventive Embodiment

Distance to the Original Surface (angstroms)

## FIG. 2A Prior Art Substrate

## FIG. 2B Inventive Embodiment

**European Patent Office**

# EUROPEAN SEARCH REPORT

Application Number

EP 95 30 5103

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US-A-3 594 238 (HOECKELMAN RALPH E) 20 July 1971 | 1-8 | C23C14/16 C23C14/58 C23C8/36 |
| Y | * column 2, line 52 - column 3, line 30 * | 9,10 | |
| X | DATABASE WPI Section Ch, Week 8620 Derwent Publications Ltd., London, GB; Class M14, AN 86-127794 & JP-A-61 064 872 ( HITACHI MAXELL) , 3 April 1986 * abstract * | 1-5,8 | |
| Y | GB-A-1 252 882 (THE BRITISH IRON AND STEEL RESEARCH ASSOCIATION) 10 November 1971 * claims 1,11,12 * | 9 | |
| Y | PATENT ABSTRACTS OF JAPAN vol. 013 no. 199 (C-594) ,11 May 1989 & JP-A-01 021068 (KOBE STEEL LTD) 24 January 1989, * abstract * | 10 | |
| A | PATENT ABSTRACTS OF JAPAN vol. 008 no. 285 (E-287) ,26 December 1984 & JP-A-59 150427 (TOSHIBA KK) 28 August 1984, * abstract * | | TECHNICAL FIELDS SEARCHED (Int.Cl.6) C23C |

The present search report has been drawn up for all claims

| Place of search | Date of completion of the search | Examiner |
|---|---|---|
| THE HAGUE | 9 November 1995 | Patterson, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)